# EUROPEAN PATENT APPLICATION

(11) **EP 4 761 562 A1**
(43) Date of publication of application: **17.06.2026**
(21) Application number: 25220980.4
(22) Date of filing: 05.12.2025
(51) Int. Cl.: H10W 90/15, H10W 70/60, H10W 70/685, H10W 40/20, H10W 40/70, H10W 40/77, H10W 90/10, H10W 90/00, H10W 90/20

(54) **SEMICONDUCTOR DEVICE**

(30) Priority: 11.12.2024 JP 2024216491
(71) Applicant: DENSO CORPORATION, Kariya-city, Aichi-pref. 448-8661 (JP); MIRISE Technologies Corporation, Nisshin-shi, Aichi-ken 470-0111 (JP)
(72) Inventor: INOUE, Norihiko, Nisshin-shi, Aichi-ken, 470-0111 (JP); SAITO, Naoyuki, Nisshin-shi, Aichi-ken, 470-0111 (JP)
(74) Representative: Kuhnen & Wacker Patent- und Rechtsanwaltsbüro PartG mbB

(57) **Abstract**

A semiconductor device (1) includes a semiconductor module (4), a component-embedded substrate (3), a support substrate (2) on which these components are mounted, and a wiring layer (7). The component-embedded substrate includes an electronic component (31, 32). The component-embedded substrate has a height equal to a height of the semiconductor module, and the electronic component has a height different from the height of the semiconductor module. The wiring layer includes wiring sections (72) each electrically connected to the power semiconductor element or the electronic component. The wiring layer is disposed on an opposite side of the semiconductor module and the component-embedded substrate from the support substrate. The electronic component has a terminal (311, 312) connected to a corresponding wiring section among the wiring sections. The terminal is positioned closer to the wiring layer than to the support substrate.

## Description

The present disclosure relates to a semiconductor device.

Conventionally, a semiconductor device has been known in which a semiconductor module having a power semiconductor element such as a metal oxide semiconductor field effect transistors (MOSFET), and one or more electronic components such as a passive component or an integrated circuit (IC) chip, are mounted on a core member having a plurality of frame-shaped cavities (see, for example, JP 2016-219535 A).

In the semiconductor device described above, a wiring layer having a plurality of wiring sections each connected to terminals of the power semiconductor element or the electronic components is formed on one surface of the core member. In this semiconductor device, the power semiconductor element and the one or more electronic components are accommodated in separate cavities, and their heat dissipation surfaces, which are opposite to the wiring layer, are arranged to be aligned.

In the semiconductor device described above, the wiring layer connected to the power semiconductor element and the electronic components is formed in the same process, and a current equal to or greater than a predetermined value flows when the power semiconductor element is driven. Thus, the wiring layer connected to the power semiconductor element and the electronic components has a thickness greater than that of signal wirings used solely for signal transmission. Additionally, in the semiconductor device described above, since the power semiconductor element has a greater component height than the electronic components, a height of vias connecting the terminals to the wiring layer is greater for the electronic components. The vias have a substantially conical shape, with their diameter increasing from a side connected to the terminals toward a side connected to the wiring layer, and the vias formed for the electronic components have a larger diameter than those formed for the semiconductor element.

When this type of semiconductor device includes multiple electronic components in addition to the power semiconductor element, in order to reliably remove, by patterning, a portion of a thick wiring layer that spans across multiple electronic components, it is necessary to ensure a space equal to or greater than a predetermined size at the portion that spans across the electronic components. In order to ensure sufficient space in the wiring layer to reliably remove the portion of the thick wiring layer that spans across the electronic components in this manner, it is necessary to increase a distance between the electronic components. In addition, in this type of semiconductor device, the diameter of the vias for the electronic components is large. Thus, a required area on the one surface of the wiring layer is increased due to the diameter of the vias and the space. Therefore, when this type of semiconductor device includes a power semiconductor element and multiple electronic components, the overall planar size of the semiconductor device increases, making miniaturization and high integration difficult.

In view of the above, it is an object of the present disclosure to provide a semiconductor device that includes a semiconductor module and at least one electronic component having different heights, with a planar size smaller than conventional devices, thereby enabling miniaturization and high integration.

A semiconductor device according to an aspect of the present disclosure includes a semiconductor module, a component-embedded substrate, a support substrate, and a wiring layer. The semiconductor module includes a power semiconductor element. The component-embedded substrate has a height equal to a height of the semiconductor module, and includes at least one electronic component embedded in the component-embedded substrate. The at least one electronic component has a height different from the height of the semiconductor module. The semiconductor module and the component-embedded substrate are mounted on the support substrate. The wiring layer includes wiring sections each electrically connected to the power semiconductor element or the at least one electronic component. The wiring layer is disposed on an opposite side of the semiconductor module and the component-embedded substrate from the support substrate. The at least one electronic component has a terminal connected to a corresponding wiring section among the wiring sections. The terminal is disposed, within the component-embedded substrate, at a position closer to the wiring layer than to the support substrate.

In this semiconductor device, the semiconductor module and the component-embedded substrate having heights equal to each other are mounted on the support substrate, the wiring layer connected to the terminal of the semiconductor module and the component-embedded substrate is disposed, and the component-embedded substrate includes the at least one electronic component having height different from that of the semiconductor module. The component-embedded substrate includes the at least one electronic component, and the terminal of the at least one electronic component is arranged at the position closer to the wiring layer than to the support substrate. Furthermore, the power semiconductor element, like the electronic component, is arranged in a position closer to the wiring layer than to the support substrate. Therefore, even in a configuration in which the semiconductor module and the multiple electronic components having different heights are mounted, the power semiconductor element and the electronic components are positioned closer to the wiring layer, thereby suppressing an increase in the diameter of vias formed on the terminals of these components. Furthermore, the component-embedded substrate is a single member including at least one electronic component, and since the wiring section connected to the terminals of the electronic component can be formed in a process separate from that for the wiring section connected to the power semiconductor element, a space between the wiring sections is reduced. Accordingly, this semiconductor device, even when including the semiconductor module and the at least one electronic component having different heights, can have a smaller planar size than conventional devices, enabling miniaturization and higher integration.
FIG. 1 is a cross-sectional view illustrating a semiconductor device of a first embodiment;
FIG. 2 is a cross-sectional view illustrating a semiconductor device of a comparative example;
FIG. 3A is a cross-sectional view illustrating a first process in a manufacturing process of the semiconductor device of FIG. 1;
FIG. 3B is a cross-sectional view illustrating a process subsequent to the process illustrated in FIG. 3A;
FIG. 3C is a cross-sectional view illustrating a process subsequent to the process illustrated in FIG. 3B;
FIG. 3D is a cross-sectional view illustrating a process subsequent to the process illustrated in FIG. 3C;
FIG. 3E is a cross-sectional view illustrating a process subsequent to the process illustrated in FIG. 3D;
FIG. 3F is a cross-sectional view illustrating a process subsequent to the process illustrated in FIG. 3E;
FIG. 3G is a cross-sectional view illustrating a process subsequent to the process illustrated in FIG. 3F;
FIG. 3H is a cross-sectional view illustrating a process subsequent to the process illustrated in FIG. 3G;
FIG. 4 is a cross-sectional view illustrating a semiconductor device of a second embodiment;
FIG. 5 is an explanatory diagram of a component-embedded substrate according to the second embodiment;
FIG. 6 is a cross-sectional view illustrating a semiconductor device of a third embodiment;
FIG. 7 is a cross-sectional view illustrating a semiconductor device of a fourth embodiment;
FIG. 8 is a cross-sectional view illustrating a component-embedded substrate of the semiconductor device of the fifth embodiment;
FIG. 9 is a cross-sectional view taken along line IX-IX in FIG. 8.
FIG. 10 is a cross-sectional view taken along line X-X in FIG. 8.
FIG. 11 is a cross-sectional view illustrating a component-embedded substrate of a comparative example;
FIG. 12 is a cross-sectional view taken along line XII-XII in FIG. 11;
FIG. 13 is a cross-sectional view taken along line XIII-XIII in FIG. 11;
FIG. 14 is a cross-sectional view illustrating a component-embedded substrate of a semiconductor device according to a sixth embodiment;
FIG. 15 is a cross-sectional view taken along line XV-XV in FIG. 14;
FIG. 16 is a cross-sectional view illustrating a component-embedded substrate of a comparative example; and
FIG. 17 is a cross-sectional view taken along line XVII-XVII in FIG. 16.

The following describes embodiments of the present disclosure with reference to the drawings. In the following embodiments, the same or equivalent parts are denoted by the same reference numerals for convenience of description.

### (First Embodiment)

A semiconductor device 1 according to a first embodiment will be described.

### [Basic Configuration]

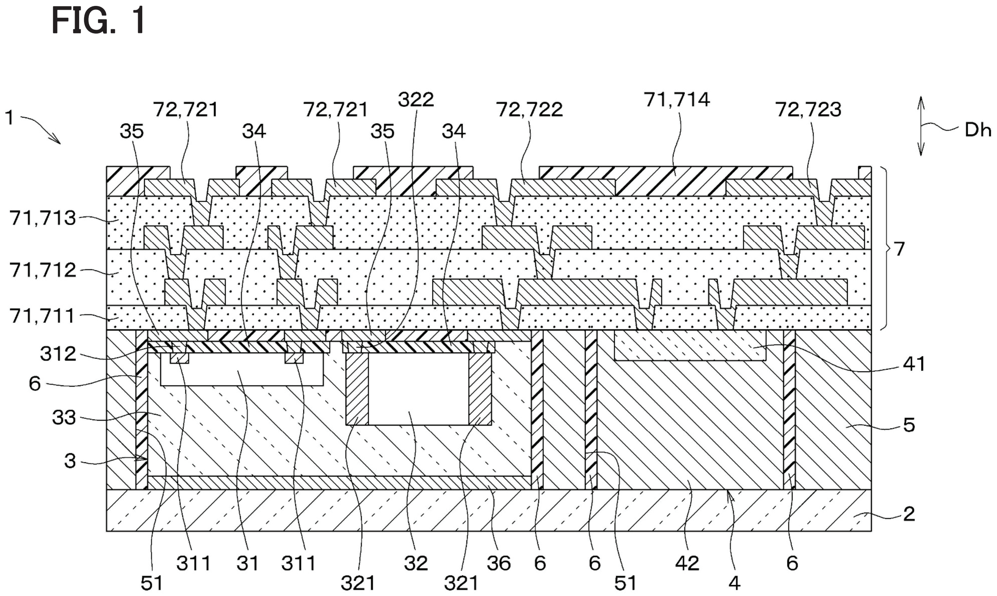

The semiconductor device 1 of the present embodiment includes, for example as illustrated in FIG. 1, a support substrate 2, a component-embedded substrate 3, a semiconductor module 4, a core member 5, a resin member 6, and a wiring layer 7. In the semiconductor device 1, the semiconductor module 4 constitutes a power circuit through which a predetermined large current flows, and the component-embedded substrate 3 constitutes a control circuit for controlling the semiconductor module 4. The semiconductor device 1 is suitably used, for example, as an electronic circuit device for various electronic equipment driven by a large current.

The support substrate 2 is a member on which the component-embedded substrate 3, the semiconductor module 4, and the core member 5 are mounted, and serves to support these components. The support substrate 2 may be any substrate capable of mounting the above-mentioned plurality of components. For example, any support body such as a printed circuit board, or an insulated heat dissipation circuit board such as an active metal brazing (AMB) substrate or a direct copper bonding (DCB) substrate, may be used as the support substrate 2. From the standpoint of efficiently dissipating the heat from the component-embedded substrate 3 and the semiconductor module 4 to the outside, it is preferable that the support substrate 2 be composed of a highly heat dissipation material with high thermal conductivity.

The component-embedded substrate 3 includes, for example, a plurality of electronic components such as an integrated circuit (IC) chip 31 and a passive component 32, as well as a sealing member 33, an insulating member 34, and wiring members 35. The component-embedded substrate 3 is formed in advance as a single control member before being mounted on the support substrate 2. In the component-embedded substrate 3, the IC chip 31 and the passive component 32 are arranged such that a surface of the IC chip 31 on which terminals 311 are formed and a surface of the passive component 32 on which terminals 321 are formed are aligned. The component-embedded substrate 3 has approximately the same height dimension as the semiconductor module 4, and the IC chip 31 and the passive component 32 are arranged closer to the wiring layer 7 than to the support substrate 2. The term "approximately the same" includes not only cases where they are completely identical, but also cases where, due to unavoidable dimensional or manufacturing process errors, they are not exactly identical but can be regarded as nearly the same. Hereinafter, for convenience of explanation, the direction along the thickness of the semiconductor device 1, as indicated by the arrows in FIG. 1 and the like, may be referred to as the "height direction Dh." The component-embedded substrate 3 needs only have at least one electronic component. However, in the present embodiment, a configuration in which two electronic components are embedded will be described as a representative example.

The IC chip 31 is, for example, a semiconductor device having an integrated circuit for signal processing or for drive control of the semiconductor module 4. The IC chip 31 has a plurality of terminals 311 disposed on one surface, and this surface is exposed from the sealing member 33. The terminals 311 of the IC chip 31 are connected to vias 312, and the vias 312 are connected to the wiring members 35. The vias 312 and the wiring members 35 are formed in advance before the component-embedded substrate 3 is mounted on the support substrate 2.

The passive component 32 is a passive element such as, for example, a capacitor, resistor, or coil. The passive component 32 has, for example, two terminals 321. The terminals 321 of the passive component 32 are connected to vias 322, and the vias 322 are connected to the wiring members 35. The vias 322, like the vias 312, are formed in advance before the component-embedded substrate 3 is mounted on the support substrate 2. The vias 312 and 322 are composed of a conductive material such as copper, for example, and are formed by electroplating. Since the vias 312 and 322 are formed in advance before the component-embedded substrate 3 is mounted on the support substrate 2, their height dimension along the height direction Dh is small, and consequently, the diameter in the planar direction of the semiconductor device 1 is also kept small.

The sealing member 33 is a member that covers surfaces of the IC chip 31 and the passive component 32 that are different from surfaces on which the vias 312 and 322 are formed. The sealing member 33 is composed of an insulating material such as a prepreg, for example.

The insulating member 34 is an insulating member that covers a part or all of the surface of the IC chip 31 on which the terminals 311 are formed and the surface of the passive component 32 on which the terminals 321 are formed. The insulating member 34 is, for example, an insulating adhesive used for fixing when arranging the IC chip 31 and the passive component 32 in the manufacturing process of the component-embedded substrate 3. The insulating member 34 has opening portions to expose the terminals 311 or the terminals 321, and the opening portions are filled with the vias 312 or the vias 322.

The wiring members 35 are formed on a surface of the component-embedded substrate 3 adjacent to the vias 312 or 322, and are connected to the vias 312 or the vias 322. The wiring members 35 are composed of any conductive material, such as copper, for example.

The metal layer 36 is a layer formed on a surface of the component-embedded substrate 3 opposite to the vias 312 and 322. The metal layer 36 is formed, for example, by electrolytic plating using the same process and material as the wiring members 35. It should be noted that the component-embedded substrate 3 is not limited to a configuration having the wiring members 35 and the metal layer 36, and may have a configuration without the metal layer 36.

The semiconductor module 4 includes, for example, a power semiconductor element 41 and a heat sink 42, with the power semiconductor element 41 mounted above the heat sink 42. The semiconductor module 4 is, for example, a vertical power semiconductor device in which a current equal to or greater than a predetermined value flows in the thickness direction of the power semiconductor element 41 and the heat sink 42. The power semiconductor element 41 is, for example, a power device such as a power MOSFET or an insulated gate bipolar transistor (IGBT), and is mounted on the heat sink 42 by means of a bonding material such as solder (not shown). The heat sink 42 is composed of a material having high thermal conductivity, such as copper, for example.

The core member 5 is a member having a plurality of cavities 51 in which the component-embedded substrate 3 and the semiconductor module 4 are disposed. The core member 5 is composed of, for example, a metal material such as copper, or a composite material including an inorganic material such as glass and a resin material. In the case of metal, the core member 5 is fixed to the support substrate 2 by means of a bonding material such as solder (not shown). In the case of a composite material, the core member 5 is fixed to the support substrate 2 by methods such as pressure bonding. The core member 5, for example, has a thickness that is equal to or greater than the thickness of the component-embedded substrate 3 and the thickness of the semiconductor module 4. The cavities 51 are through-holes, and planar sizes of the cavities 51 are larger than those of the component-embedded substrate 3 and the semiconductor module 4. The cavities 51 are formed by any desired method, such as drilling, photolithographic etching, or laser processing.

The resin member 6 fills gaps between each cavity 51 of the core member 5 and the component-embedded substrate 3 or the semiconductor module 4. The resin member 6 is composed, for example, of a resin material in a prepreg that constitutes an insulating layer 71 of the wiring layer 7.

The wiring layer 7 is formed on a side of the semiconductor device 1 opposite to the support substrate 2, with the component-embedded substrate 3 and the semiconductor module 4 interposed in between, and includes the insulating layer 71 and a plurality of wiring sections 72. The insulating layer 71 is formed, for example, by laminating a plurality of layers such as a first layer 711, a second layer 712, a third layer 713, and a fourth layer 714. The first layer 711, second layer 712, and third layer 713 are composed, for example, of prepreg. The fourth layer 714 is composed, for example, of solder resist. The first layer 711 is formed with a plurality of opening portions, for example, by laser processing or the like, and the wiring sections 72 formed on the first layer 711 are each electrically connected to the wiring members 35 of the component-embedded substrate 3 or to terminals (not shown) of the power semiconductor element 41 via these opening portions. The second layer 712 and the third layer 713, like the first layer 711, are formed with a plurality of opening portions, and the wiring sections 72 are led out to the fourth layer 714 through these opening portions. The fourth layer 714 is formed with a plurality of opening portions, for example, by photolithographic etching, to expose portions of the wiring section 72 to the outside.

The plurality of wiring sections 72 are formed on each of the layers 711 to 713 constituting the insulating layer 71, and are connected to terminals of any of the IC chip 31, the passive component 32, or the power semiconductor element 41 of the component-embedded substrate 3. The plurality of wiring sections 72 are composed of any conductive material, such as copper, for example. The plurality of wiring sections 72 are formed, for example, by electroplating and are patterned into predetermined shapes by photolithographic etching. The plurality of wiring sections 72 are partially exposed to the outside on the outermost layer of the insulating layer 71, and are connected to wires or the like (not shown).

In FIG. 1, an example is shown in which the insulating layer 71 has a laminated structure of the four layers 711 to 714 and includes the four wiring sections 72. However, the present disclosure is not limited to this example. The number of layers of the insulating layer 71 and the number of the wiring sections 72 can be changed as appropriate.

The above is the basic configuration of the semiconductor device of the present embodiment. The semiconductor device 1 itself can also be regarded as one large component-embedded substrate incorporating the component-embedded substrate 3. In the present specification, the term "component-embedded substrate" refers to a small member that includes at least one electronic component and is incorporated into the semiconductor device 1, unless otherwise specified.

### [Miniaturization Effect of Semiconductor Device]

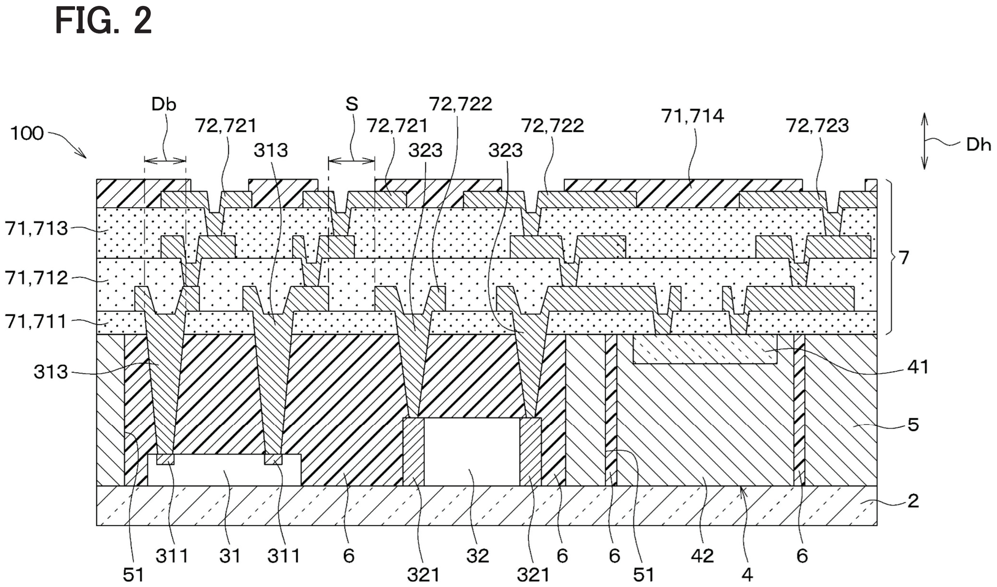

Next, miniaturization and higher integration effects of the semiconductor device 1 will be described in comparison with a semiconductor device 100 of a comparative example shown in FIG. 2.

As illustrated in FIG. 2, the semiconductor device 100 of the comparative example differs from semiconductor device 1 in that the semiconductor device 100 does not include the component-embedded substrate 3, and the IC chip 31 and passive component 32 are arranged on the support substrate 2, with vias 313 and 323 formed to directly connect the wiring sections 72 of the wiring layer 7 to the IC chip 31 and the passive component 32.

The IC chip 31 and the passive component 32 are mounted directly on the support substrate 2 and have a lower height than the semiconductor module 4. Therefore, the height dimension of the vias 313 and 323 along the height direction Dh becomes larger than the height dimension of vias that are connected to the semiconductor module 4. In addition, the vias 313 and 323 are formed, for example, by first forming inverted conical through-holes in the resin member 6 by laser processing or the like, and then filling these through-holes by electrolytic plating. Thus, a diameter Dp at portions of the vias 313 and 323 in contact with the wiring sections 72 of the wiring layer 7 becomes larger.

In addition, in the semiconductor device 100 of the comparative example, the plurality of wiring sections 72 in the wiring layer 7 are respectively connected to the IC chip 31, the passive component 32, and the power semiconductor element 41, but the plurality of wiring sections 72 are formed in the same process. Since the plurality of wiring sections 72 include at least a wiring section 723 that is connected to the power semiconductor element 41 of the semiconductor module 4, not only the wiring section 723 but also the other wiring sections 721 and 722 are similarly provided with a thickness equal to or greater than a predetermined value to accommodate large currents. On the other hand, among the plurality of wiring sections 72, the wiring sections 721 connected to the IC chip 31 are separated by patterning so that they are not directly connected to the wiring section 722 connected to the passive component 32. Therefore, from the two perspectives that the plurality of wiring sections 72 need to be made thick to accommodate large currents, and that the wiring sections 721 and 722 need to be reliably separated by patterning, it is necessary to secure a space S equal to or greater than a predetermined value between the adjacent wiring sections 721 and 722. Therefore, in order to secure the above-mentioned space S, the distance between the IC chip 31 and the passive component 32 on the support substrate 2 is set to be equal to or greater than the predetermined value.

In the semiconductor device 100 of the comparative example, due to two factors that the diameter Dp of the vias 313 and 323 increases and the space S between the wiring sections 721 and 722 increases, the size in the planar direction becomes larger, making miniaturization and higher integration difficult.

In contrast, in the semiconductor device 1 of the present embodiment, the IC chip 31 and the passive component 32 are configured as a single component, namely the component-embedded substrate 3, before being mounted on the support substrate 2. Furthermore, the vias 312 and 322 have a smaller height dimension and a smaller diameter than the vias 313 and 323 in the semiconductor device 100 of the comparative example. Therefore, the IC chip 31 and the passive component 32 are arranged closer together than in the semiconductor device 100 of the comparative example.

Additionally, in the semiconductor device 1, the component-embedded substrate 3 is arranged so that its dimension in the height direction Dh is approximately the same as that of the semiconductor module 4, and the surfaces of the IC chip 31 and the passive component 32 on which the terminals 311, 321 are formed (hereinafter referred to as "terminal forming surfaces") are positioned closer to the wiring layer 7 than to the support substrate 2. Furthermore, the wiring sections 721 and 722 of the wiring layer 7 are connected to the wiring members 35 of the component-embedded substrate 3. Therefore, even if the distance between the IC chip 31 and the passive component 32 is small, sufficient space can be secured for the adjacent wiring sections 721 and 722 of the wiring layer 7, compared to the semiconductor device 100 of the comparative example.

Therefore, by using the component-embedded substrate 3, the semiconductor device 1 can reduce the distance between the IC chip 31 and the passive component 32, while securing sufficient space between the wiring sections 721 and 722 in the wiring layer 7, resulting in a smaller planar size compared to the comparative example. Therefore, semiconductor device 1 can be miniaturized and highly integrated.

### [Manufacturing Process of Semiconductor Device]

Next, an example of a manufacturing method for the semiconductor device 1 will be described.

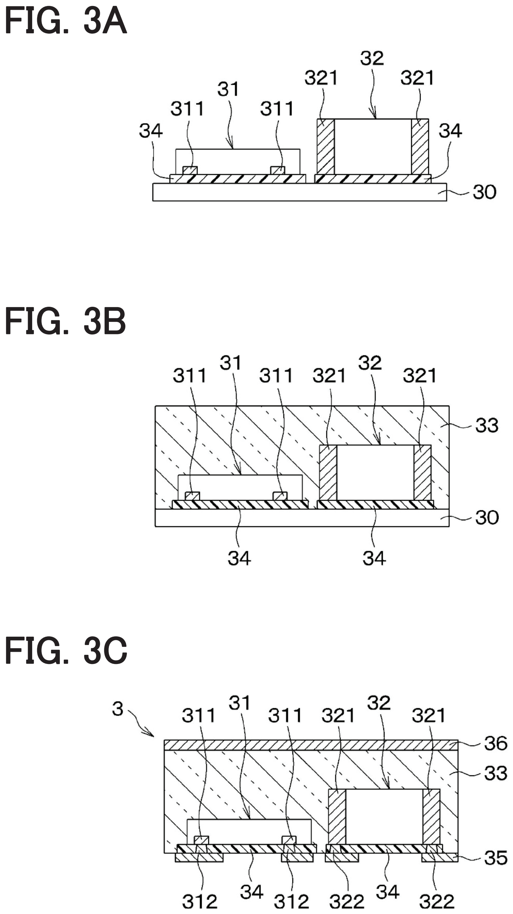

First, as illustrated for example in FIG. 3A, a support body 30, the IC chip 31, and the passive component 32 are prepared, and the IC chip 31 and the passive component 32 are temporarily fixed onto the support body 30 using the insulating member 34 having adhesive properties. At this time, the IC chip 31 and the passive component 32 are temporarily fixed with the surfaces on which the terminals 311 and 321 are formed facing the support body 30, and these surfaces are aligned. As the support body 30, for example, a film support made of any resin material can be used.

Subsequently, as illustrated for example in FIG. 3B, the IC chip 31 and the passive component 32, which have been temporarily fixed on the support body 30, are covered with the sealing member 33. As the sealing member 33, for example, a prepreg can be used. In this case, the resin material in the prepreg can seal the IC chip 31 and the passive component 32.

Next, as illustrated for example in FIG. 3C, the support body 30 is removed by any method such as laser release, and then the vias 312 and 322, the wiring members 35, and the metal layer 36 are formed. The vias 312, 322 and the wiring members 35 are formed, for example, by first forming through-holes in the insulating member 34 to expose portions of the terminals 311, 321 through laser processing or the like, then forming a seed layer (not shown) by sputtering or similar means, and subsequently performing electrolytic plating and photolithographic etching. The metal layer 36 is formed, for example, simultaneously during the plating process in which the vias 312, 322 and the wiring members 35 are formed by electrolytic plating. Through the above processes, it is possible to manufacture the component-embedded substrate 3.

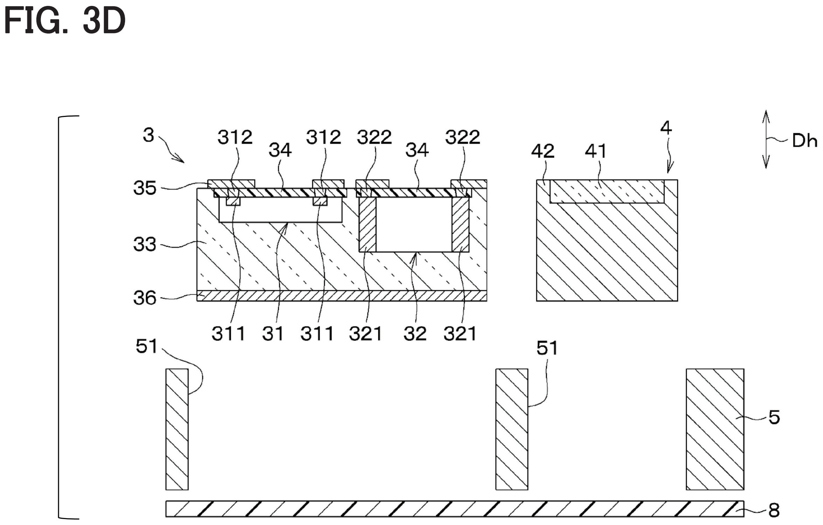

Thereafter, as illustrated for example in FIG. 3D, in addition to the component-embedded substrate 3, a temporary fixing tape 8, the semiconductor module 4, and the core member 5 are prepared. The core member 5 is pre-formed with a plurality of cavities 51 that serve as spaces for accommodating the mounted components. The arrangement and size of the plurality of cavities 51 are appropriately modified according to the layout and dimensions of the components to be mounted, such as the component-embedded substrate 3 and the semiconductor module 4. The temporary fixing tape 8 is used to attach and secure the component-embedded substrate 3, the semiconductor module 4, and the core member 5 until the wiring layer 7 is formed.

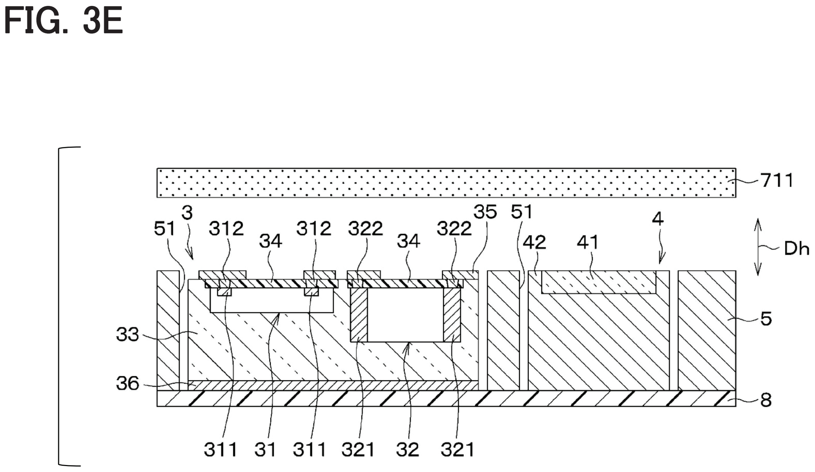

Then, as illustrated for example in FIG. 3E, the component-embedded substrate 3, the semiconductor module 4, and the core member 5 are temporarily fixed by attaching them to the temporary fixing tape 8. At this time, the component-embedded substrate 3 and the semiconductor module 4 are each placed within different cavities 51. Furthermore, as the insulating member constituting the first layer 711 of the insulating layer 71, for example, a prepreg is prepared. In the process illustrated in FIG. 3E, it is sufficient if each component can be temporarily fixed. Therefore, in addition to the temporary fixing tape 8, an adhesive may also be used as necessary. In this manner, the members or methods used for the temporary fixing of the component-embedded substrate 3, the semiconductor module 4, and the core member 5 may be appropriately changed as necessary.

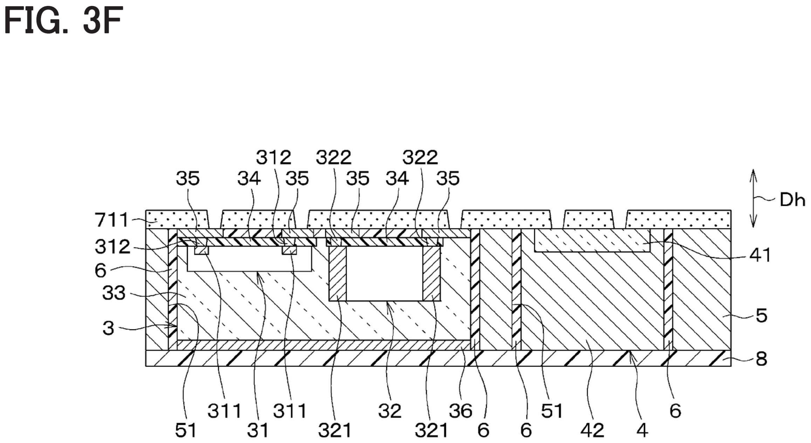

Subsequently, as illustrated for example in FIG. 3F, after placing the first layer 711 so as to cover surfaces of the component-embedded substrate 3, the semiconductor module 4, and the core member 5, thermal compression bonding is performed to adhere the component-embedded substrate 3, the semiconductor module 4, and the core member 5 to the first layer 711. Through this process, the gap between each cavity 51 of the core member 5 and the component-embedded substrate 3 or the semiconductor module 4 is filled with the resin material in the first layer 711, thereby forming the resin member 6. Then, for example, laser processing is performed on the first layer 711 to form opening portions that expose portions of the wiring member 35 of the IC chip 31, the wiring member 35 of the passive component 32, and terminals (not shown) of the semiconductor module 4.

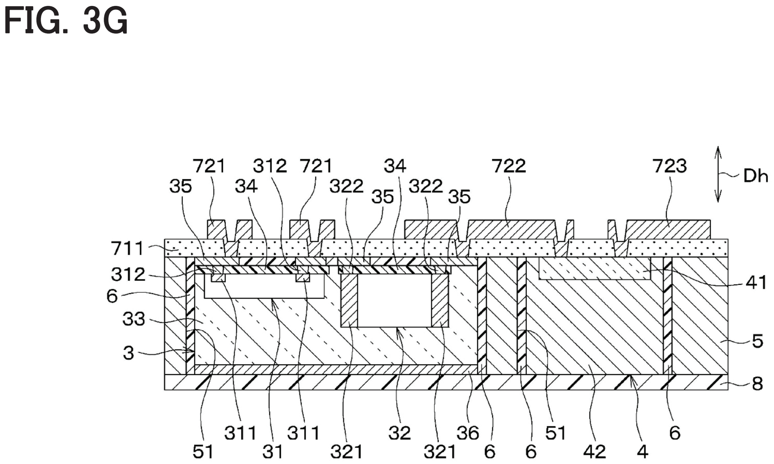

Next, a seed layer (not shown) is formed on the first layer 711 and its opening portions, and a metal film that constitutes vias filling the opening portions and the wiring sections 72 is formed by electrolytic plating. Then, after forming a resist (not shown) on the metal film, portions of the wiring sections are formed by patterning the resist film and the metal film through photolithography and etching, and the resist film is removed using a stripping solution or the like. As a result, as illustrated for example in FIG. 3G, portions of wiring sections 721 to 723 are formed in the first layer 711, along with the vias that are connected to the component-embedded substrate 3 or the semiconductor module 4.

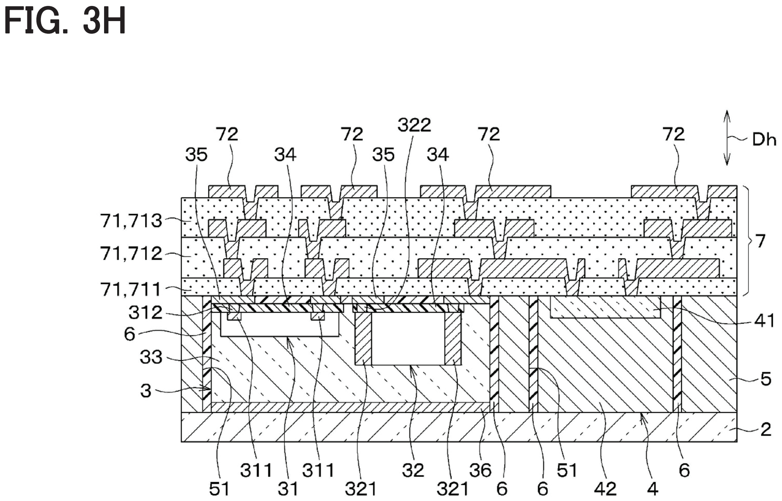

Subsequently, for example, by repeating processes similar to those used for forming the first layer 711, the vias and the wiring sections, the second layer 712, the third layer 713, and the wiring sections 72 are laminated on top of the first layer 711, as illustrated in FIG. 3H. At this time, for example, the support substrate 2 is prepared, the temporary fixing tape 8 is peeled off from a workpiece in which a prepreg that constitutes the third layer 713 is thermocompression-bonded onto the second layer 712, and a surface of the workpiece exposing the component-embedded substrate 3 and the semiconductor module 4 is connected to the support substrate 2. Subsequently, by processing the prepreg laminated on the second layer 712 and laminating the wiring sections 72, the state illustrated in FIG. 3H is achieved. Then, for example, after pattern-coating solder resist onto the third layer 713 and the wiring section 72 by screen printing or the like, the solder resist is cured by heating or ultraviolet irradiation, thereby forming the fourth layer 714 in a patterned shape with opening portions that expose portions of the plurality of wiring sections 72.

Through the above processes, the semiconductor device 1 of the present embodiment can be manufactured.

According to the present embodiment, the semiconductor device 1 includes the component-embedded substrate 3 in which the distance between the IC chip 31 and the passive component 32 is small, and the power semiconductor element 41, and the diameters of the vias connected to the wiring layer 7 are made small. Thus, the semiconductor device 1 can be miniaturized and highly integrated.

### (Second Embodiment)

A semiconductor device 1 of a second embodiment will be described.

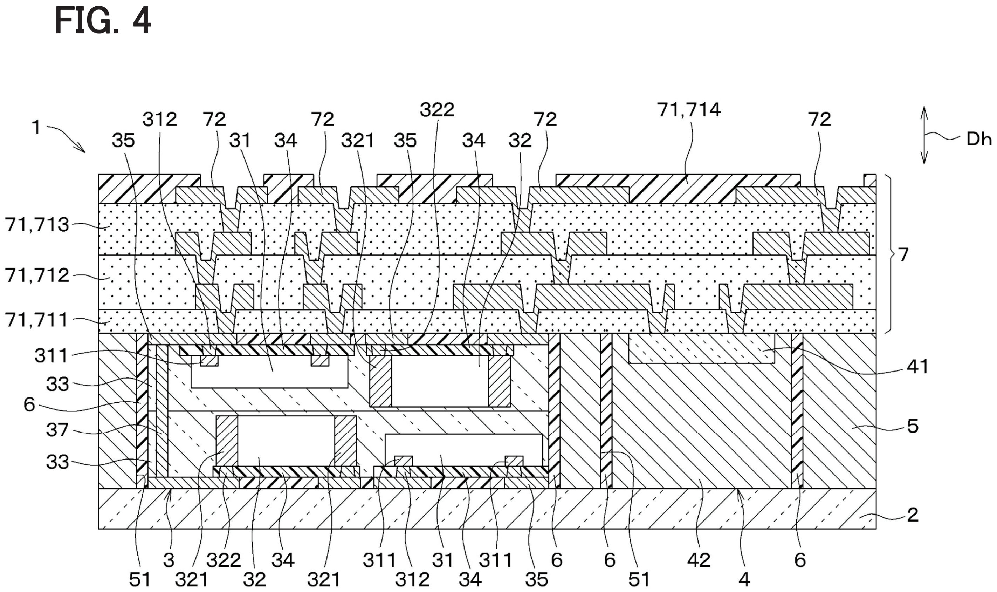

In the semiconductor device 1 of the present embodiment, for example as illustrated in FIG. 4, the configuration of the component-embedded substrate 3 differs from that of the first embodiment described above. The following describes the difference between the present embodiment and the first embodiment.

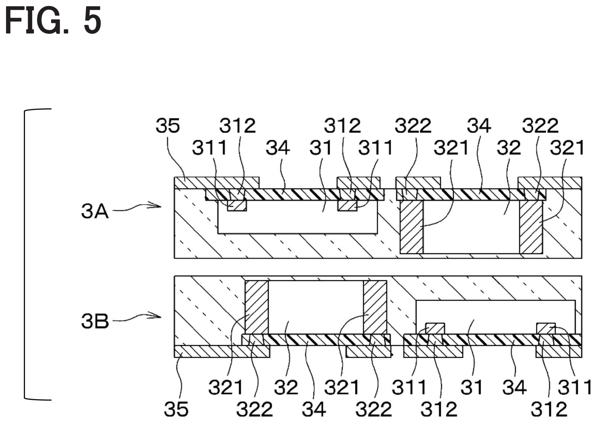

In the present embodiment, for example, the component-embedded substrate 3 includes two IC chips 31 and two passive components 32, and these members are electrically connected by through electrodes 37 formed along the height direction Dh of the sealing member 33. As illustrated in FIG. 5, for example, the component-embedded substrate 3 is manufactured by first producing a first member 3A and a second member 3B having the same configuration as in the first embodiment except for the thickness of the sealing member 33, and then bonding these members together back-to-back at the surfaces of the sealing member 33. In other words, the first member 3A has one surface on which the terminal forming surfaces of the IC chip 31 and the passive component 32 embedded in the first member 3A are aligned, and a rear surface opposite to the one surface. The second member 3B has one surface on which the terminal forming surfaces of the IC chip 31 and the passive component 32 embedded in the second member 3B are aligned, and a rear surface opposite to the one surface. The rear surface of the first member 3A and the rear surface of the second member 3B are bonded to each other. For example, the component-embedded substrate 3 is bonded by any suitable method, such as bonding the first member 3A and the second member 3B with an adhesive (not shown), or by compression bonding using a prepreg. However, the height dimension is approximately the same as that of the semiconductor module 4. For example, after the first member 3A and the second member 3B are bonded together, a through hole penetrating the sealing member 33 of these members is formed in the component-embedded substrate 3 by any suitable method such as laser processing or drilling. Then, for example, the component-embedded substrate 3 is provided with through electrodes 37 that fill the through holes penetrating the sealing member 33 of the first member 3A and the second member 3B.

For example, in the component-embedded substrate 3, the IC chip 31 and the passive component 32 of the first member 3A are disposed at positions closer to the wiring layer 7, while the IC chip 31 and the passive component 32 of the second member 3B are disposed at positions closer to the support substrate 2. For example, in the component-embedded substrate 3, in the height direction Dh, the IC chip 31 of the first member 3A faces the passive component 32 of the second member 3B, and the passive component 32 of the first member 3A faces the IC chip 31 of the second member 3B. In the component-embedded substrate 3 of the present embodiment, the IC chip 31 and the passive component 32 are arranged in a region consisting only of the sealing member 33, that is, a dead space created solely due to the difference in height dimensions with the semiconductor module 4 in the first embodiment.

According to the present embodiment, in addition to the effects of the first embodiment described above, the dead space within the component-embedded substrate 3 is effectively utilized, resulting in the semiconductor device 1 that achieves improved integration density of electronic components.

### (Third Embodiment)

A semiconductor device 1 of a third embodiment will be described.

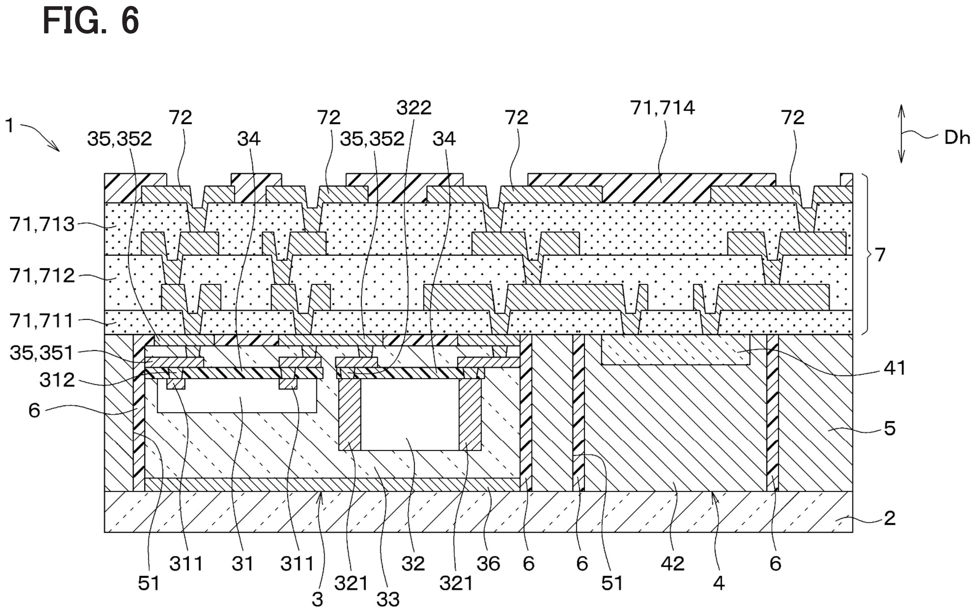

In the semiconductor device 1 of the present embodiment, as illustrated for example in FIG. 6, the configuration of the component-embedded substrate 3 differs from that of the first embodiment described above. The following describes the difference between the present embodiment and the first embodiment.

In the component-embedded substrate 3 of the present embodiment, the wiring members 35 connected to the IC chip 31 and the passive component 32 include a first wiring layer 351 and a second wiring layer 352 stacked in the height direction Dh. The wiring members 35 are formed, for example, by stacking the first wiring layer 351 and the second wiring layer 352 in this order from a side close to the IC chip 31 and the passive component 32, through processes similar to those used for the wiring sections 72 of the wiring layer 7. By adopting the wiring members 35 having the multilayer structure, the component-embedded substrate 3 improves the flexibility of the signal transmission wiring layout connected to the IC chip 31 and the passive component 32, compared to the case of single-layer wiring. This enables miniaturization and higher integration.

It should be noted that, in FIG. 6, the wiring members 35 are illustrated as a representative example with a two-layer structure consisting of the first wiring layer 351 and the second wiring layer 352. However, the present disclosure is not limited to this example, and the number of layers or wiring patterns of the wiring members 35 may be changed as appropriate. The wiring members 35 are formed as multilayer wiring in advance before being mounted onto the support substrate 2.

According to the present embodiment, the effects of the first embodiment described above can be obtained. In addition, the degree of freedom in the layout of the wiring members 35 in the component-embedded substrate 3 is improved. Thus, the semiconductor device 1 can have a structure that further enhances the miniaturization and high integration effect.

### (Fourth Embodiment)

A semiconductor device 1 of a fourth embodiment will be described.

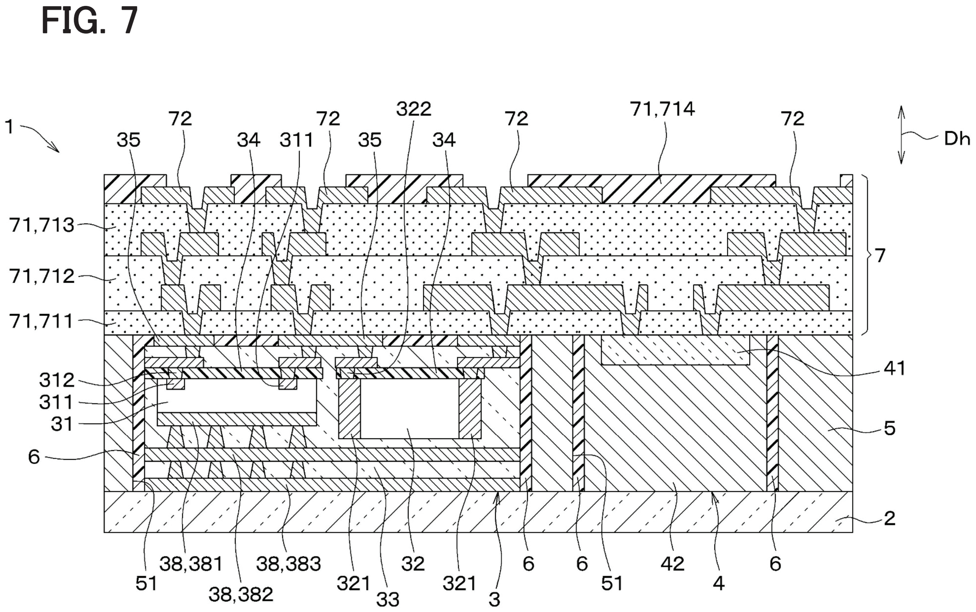

In the semiconductor device 1 of the present embodiment, for example as illustrated in FIG. 7, the configuration of the component-embedded substrate 3 differs from that of the first embodiment described above. The following describes the difference between the present embodiment and the first embodiment.

In the present embodiment, the component-embedded substrate 3 is configured such that a heat dissipation wiring section 38 for heat dissipation is formed on a heat dissipation surface of the IC chip 31, which is a surface opposite to the terminals 311. The heat dissipation wiring section 38 is composed of a metal material with high thermal conductivity, such as copper, and is formed by lamination in processes similar to those used for the wiring sections 72 of the wiring layer 7. The heat dissipation wiring section 38 is formed, for example, by sequentially stacking a first heat dissipation layer 381, a second heat dissipation layer 382, and a third heat dissipation layer 383 in this order from a side close to the IC chip 31, with these layers being connected to each other through vias. The heat dissipation wiring section 38 serves as a heat dissipation path that transfers the heat from the IC chip 31 toward the support substrate 2.

It should be noted that, although FIG. 7 illustrates an example in which the heat dissipation wiring section 38 has a three-layer laminated structure as described above, the configuration of the heat dissipation wiring section 38 is not limited to this example. The number of layers, wiring patterns, and the like of the heat dissipation wiring section 38 may be appropriately modified. The first heat dissipation layer 381, the second heat dissipation layer 382, and the third heat dissipation layer 383 may, for example, have a solid shape that covers the entire area in the plane direction of the component-embedded substrate 3. In another example, the first heat dissipation layer 381, the second heat dissipation layer 382, and the third heat dissipation layer 383 may also be formed in a predetermined patterned shape. The heat dissipation wiring section 38 may be connected not only to the IC chip 31 but also to the passive component 32, or may be connected only to the passive component 32, and the target for heat dissipation may be appropriately modified.

Furthermore, in FIG. 7, the wiring members 35 have a configuration in which multiple wiring layers are laminated via the sealing member 33 in a manner similar to the third embodiment described above. However, the configuration of the wiring members 35 is not limited to this example, and the wiring members 35 may have a single-layer configuration. For the wiring members 35 and the heat dissipation wiring section 38, it is preferable that the layers constituting them are formed in the same process and the number of layers is the same from the standpoint of reducing the manufacturing cost.

According to the present embodiment, the effects of the first embodiment can be obtained. In addition, the semiconductor device 1 can have a structure in which the heat dissipation of the electronic components embedded in the component-embedded substrate 3 is improved.

### (Fifth Embodiment)

A semiconductor device 1 of a fifth embodiment will be described.

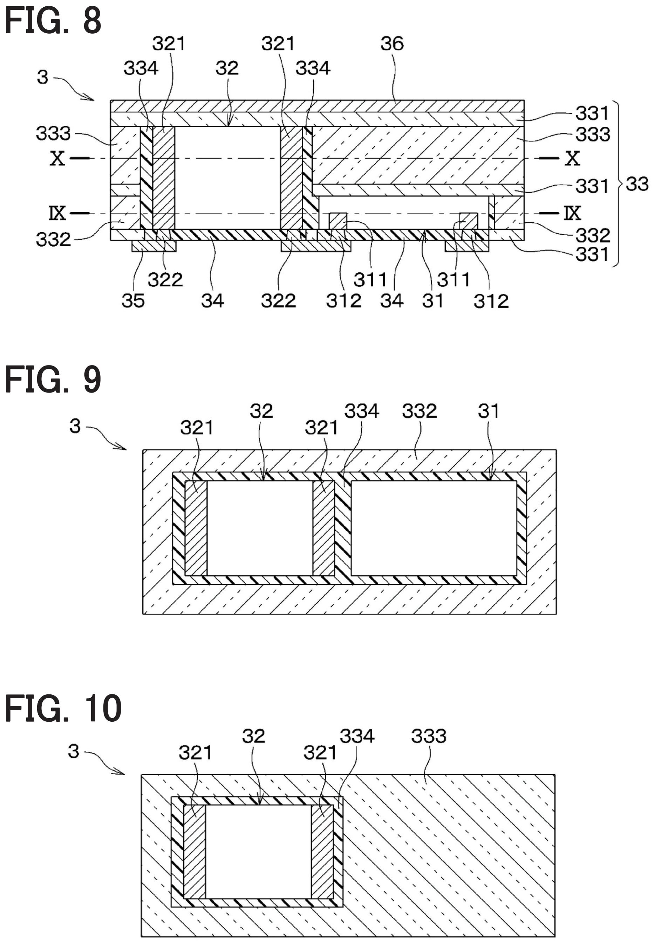

In the semiconductor device 1 of the present embodiment, for example as illustrated in FIG. 8, the configuration of the component-embedded substrate 3 differs from that of the first embodiment described above. The following describes the difference between the present embodiment and the first embodiment.

In the present embodiment, as illustrated in FIG. 8, the component-embedded substrate 3 includes a sealing member 33 having a plurality of prepreg layers 331, a core layer 332, an auxiliary core layer 333, and a resin layer 334. The sealing member 33 is formed, for example, by laminating the prepreg layer 331, the core layer 332, the prepreg layer 331, the auxiliary core layer 333, and the prepreg layer 331 in this order from a side close to the terminal forming surfaces of the IC chip 31 and the passive component 32. The sealing member 33 is configured such that the resin layer 334 fills the gaps between the IC chip 31 or the passive component 32 and the prepreg layer 331, the core layer 332, and the auxiliary core layer 333.

The prepreg layers 331 are, for example, each disposed on the terminal forming surfaces of the IC chip 31 and the passive component 32, on a rear surface of the IC chip 31, and on a rear surface of the passive component 32. The term "rear surface" refers to the surface located on the opposite side of the terminal forming surface. The prepreg layer 331 disposed on the rear surface of the IC chip 31 is formed, for example, as a single continuous frame body having an opening that surrounds the passive component 32, similar to the core layer 332 described later. The prepreg layer 331 disposed on the rear surface of the passive component 32 is formed, for example, in a rectangular plate shape that covers the entire area of the passive component 32 and the auxiliary core layer 333 described later.

The core layer 332 is formed, for example, in the same manner as the prepreg layer 331, using a base material such as glass cloth or carbon fiber, and a thermosetting resin material. The core layer 332 is a member in which the thermosetting resin material is more cured than in the prepreg layer 331, resulting in a harder state than the prepreg layer 331. The core layer 332 is a member that hardly deforms when laminated onto the prepreg layer 331. The core layer 332 is adjusted, for example, so that its height when laminated onto the prepreg layer 331 is approximately equal to the height of the IC chip 31. As illustrated for example in FIG. 9, the core layer 332 has opening portions that surround the IC chip 31 and the passive component 32, and forms a single continuous frame shape.

The auxiliary core layer 333 is, for example, configured in the same manner as the core layer 332, and is disposed on the IC chip 31 via the prepreg layer 331. As illustrated for example in FIG. 10, the auxiliary core layer 333 covers the IC chip 31 and has a single continuous frame shape that surrounds only the passive component 32. The auxiliary core layer 333 is a member that fills the gap caused by the difference in height between the IC chip 31 and the passive component 32, thereby ensuring the flatness of the component-embedded substrate 3, preventing a decrease in strength and deterioration of pressure resistance of the component-embedded substrate 3, and improving reliability.

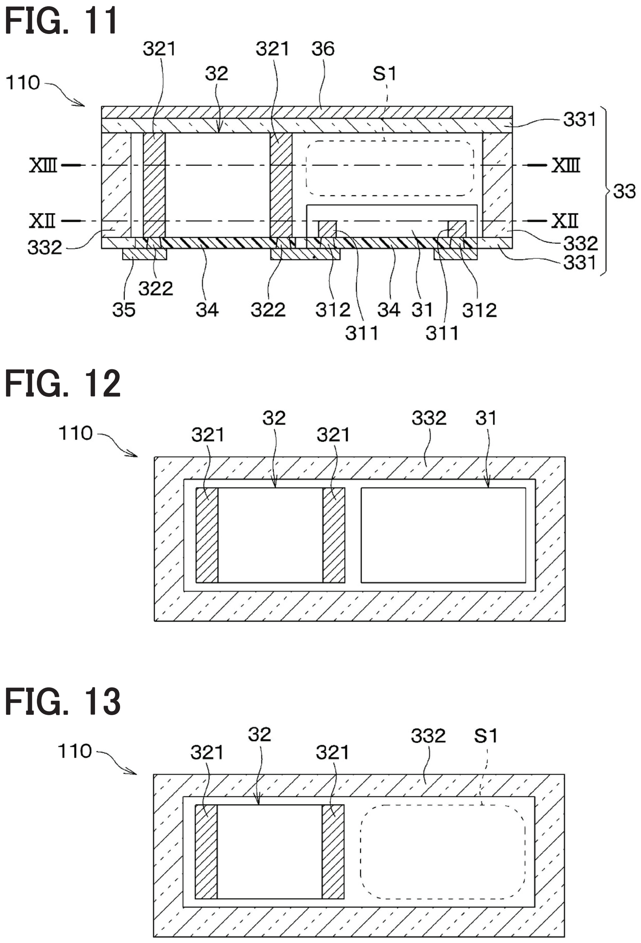

Here, for example, a case will be considered in which the sealing member 33 does not include the auxiliary core layer 333, as in a component-embedded substrate 110 of a comparative example illustrated in FIG. 11. Except for the configuration of the sealing member 33, the component-embedded substrate 110 of the comparative example has the same configuration as the component-embedded substrate 3. In the component-embedded substrate 110 of the comparative example, the sealing member 33 includes a plurality of prepreg layers 331 and a core layer 332, but does not include an auxiliary core layer 333. Furthermore, as illustrated for example in FIG. 12 and FIG. 13, the core layer 332 has a continuous, single frame shape with a single opening portion that surrounds both the IC chip 31 and the passive component 32. In this case, due to the height difference between the IC chip 31 and the passive component 32, a space S1, as indicated by the dashed line in FIG. 13, is formed between the IC chip 31 and the prepreg layer 331 disposed above the passive component 32. In addition, although the space S1 is to be filled by the resin material in the prepreg layer 331 disposed above the passive component 32, if the space S1 is large, it may not be completely filled with the resin material, which can lead to a decrease in strength or deterioration in breakdown voltage.

Among a plurality of electronic components included in the component-embedded substrate 3, an electronic component with the greatest height is defined as a highest electronic component, and an electronic component other than the highest electronic component is defined as a different electronic component. The auxiliary core layer 333 may be configured such that the auxiliary core layer 333 is disposed above the different electronic component and serves to compensate for the height difference between the highest electronic component and the different electronic component. Therefore, the auxiliary core layer 333 is not limited to being disposed above the IC chip 31. If the IC chip 31 has a greater component height than the passive component 32, the auxiliary core layer 333 may instead be disposed above the passive component 32. Furthermore, if the component-embedded substrate 3 includes, in addition to the IC chip 31 and the passive component 32, other electronic components, the placement of the auxiliary core layer 333 may be appropriately adjusted depending on the height relationship among the plurality of electronic components, so that the auxiliary core layer 333 is disposed above whichever electronic component that is suitable.

According to the present embodiment, the effects of the first embodiment described above can be obtained. In addition, the flatness and strength of the component-embedded substrate 3 can be ensured. Therefore, the semiconductor device 1 can have a structure in which a decrease in breakdown voltage is suppressed and reliability is improved.

### (Sixth Embodiment)

A semiconductor device 1 according to a sixth embodiment will be described.

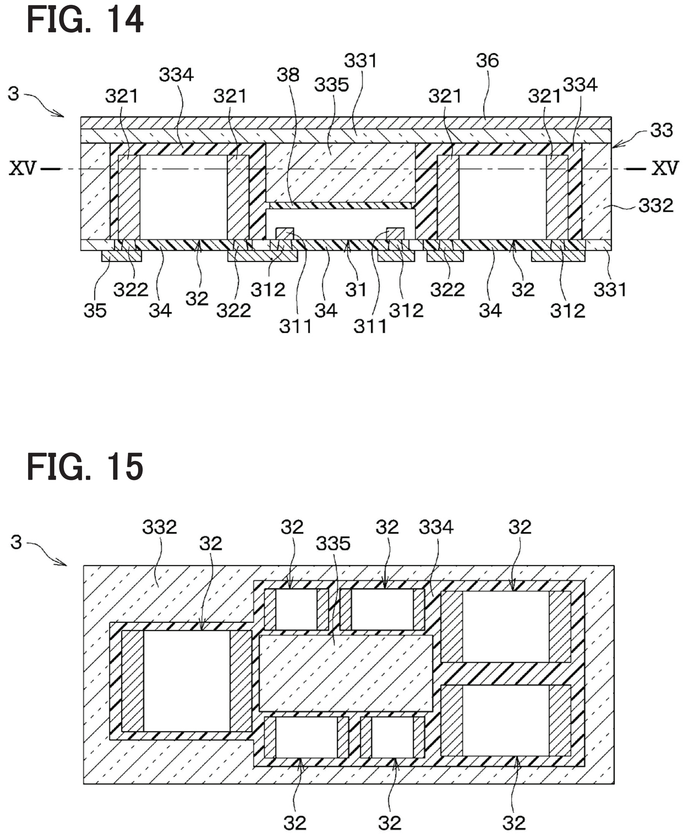

In the present embodiment, as illustrated for example in FIG. 14, the configuration of the component-embedded substrate 3 differs from that of the first embodiment described above. The following describes the difference between the present embodiment and the first embodiment.

In the present embodiment, as illustrated for example in FIG. 14, the component-embedded substrate 3 includes a sealing member 33 that includes a plurality of prepreg layers 331, a core layer 332, a resin layer 334, and an independent auxiliary core layer 335. As illustrated for example in FIG. 14 and FIG. 15, the component-embedded substrate 3 includes a single IC chip 31 and a plurality of passive components 32, and the plurality of passive components 32 are arranged so as to surround the IC chip 31. The sealing member 33 is formed by laminating the prepreg layer 331, the core layer 332, and the prepreg layer 331 in this order from a side close to the terminal forming surfaces of the IC chip 31 and the passive components 32. In the sealing member 33, the single independent auxiliary core layer 335 is disposed within the region surrounded by the core layer 332 having a frame shape. In the sealing member 33, the gaps between the IC chip 31, the plurality of passive components 32, the core layer 332, and the independent auxiliary core layer 335 are filled with the resin layer 334.

In the present embodiment, the core layer 332 has a single continuous frame shape with one large opening portion that surrounds the IC chip 31 and the plurality of passive components 32. For example, the height of the core layer 332 is greater than those of the IC chip 31 and the plurality of passive components 32.

For example, the independent auxiliary core layer 335 is disposed on the electronic component with the smallest height among the plurality of electronic components included in the component-embedded substrate 3, and serves as a member that compensates for the height differences between these electronic components. As illustrated for example in FIG. 14 and FIG. 15, the independent auxiliary core layer 335 is disposed within the opening portion of the core layer 332, placed above the IC chip 31, and fills the space caused by the height difference between the IC chip 31 and the passive components 32. The independent auxiliary core layer 335 is fixed onto the IC chip 31, for example, with an adhesive (not shown), ensuring that no positional displacement occurs when the prepreg layer 331 is laminated and pressed onto the core layer 332. The independent auxiliary core layer 335 is a member that fills the space caused by differences in height among the plurality of electronic components, thereby ensuring the flatness of the component-embedded substrate 3, preventing a decrease in the strength and deterioration in the breakdown voltage of the component-embedded substrate 3, and improving reliability.

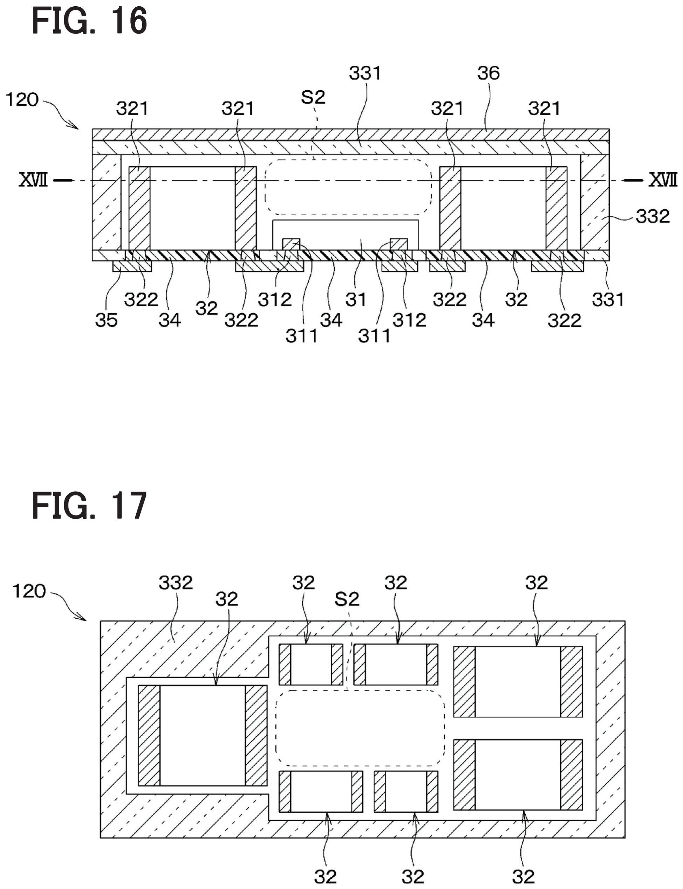

For example, when the sealing member 33 has a configuration that does not include the independent auxiliary core layer 335, as in a component-embedded substrate 120 of a comparative example illustrated in FIG. 16, a space S2 indicated by a dashed line is formed above the IC chip 31 within the sealing member 33 due to the difference in height with the passive components 32 surrounding the IC chip 31. The component-embedded substrate 120 of the comparative example has the same structure as the component-embedded substrate 3, except that the component-embedded substrate 120 does not include the independent auxiliary core layer 335. As illustrated for example in FIG. 17, the component-embedded substrate 120 of the comparative example has the space S2 formed within the sealing member 33 and surrounded by the plurality of passive components 32. Thus, it is necessary to fill the space S2 with the resin material in the prepreg layer 331 that is disposed on the core layer 332. However, in the component-embedded substrate 120 of the comparative example, if the space S2 is large, it may not be possible to completely fill the space S2 with the resin material, resulting in an inability to ensure flatness and strength, and deterioration in breakdown voltage may occur.

On the other hand, in the component-embedded substrate 3 according to the present embodiment, the space S2 is filled with the independent auxiliary core layer 335, ensuring the flatness of the prepreg layer 331 mounted on the core layer 332, and suppressing reduction in strength and deterioration in breakdown voltage. It should be noted that the independent auxiliary core layer 335 may be provided not only as a single piece, but also as a plurality of pieces. The number, arrangement, shape, and the like of the independent auxiliary core layer 335 can be appropriately changed according to the height relationships and arrangement among the plurality of electronic components included in the component-embedded substrate 3.

According to the present embodiment, the effects of the first embodiment described above can be obtained. In addition, the flatness and strength of the component-embedded substrate 3 can be ensured. Therefore, the semiconductor device 1 can have a structure in which a decrease in breakdown voltage is suppressed and reliability is improved.

### (Other Embodiments)

Although the present disclosure has been made in accordance with the embodiments, it is understood that the present disclosure is not limited to such embodiments and structures. The present disclosure encompasses various modifications and variations within the scope of equivalents. In addition, various combinations and modes, and other combinations and modes including only one element, more elements, or fewer elements are also within the scope and idea of the present disclosure.

The constituent element(s) of each of the above embodiments is/are not necessarily essential unless it is specifically stated that the constituent element(s) is/are essential in the above embodiment, or unless the constituent element(s) is/are obviously essential in principle. A quantity, a value, an amount, a range, or the like referred to in the description of the embodiments described above is not necessarily limited to such a specific value, amount, range or the like unless it is specifically described as essential or understood as being essential in principle. Furthermore, a shape, positional relationship or the like of a structural element, which is referred to in the embodiments described above, is not limited to such a shape, positional relationship or the like, unless it is specifically described or obviously necessary to be limited in principle.

### (Various Aspects of Present Disclosure)

The present disclosure described above can be understood from the following features, for example.

It should be noted that reference numerals in parentheses assigned to each component or the like indicate one example of a correspondence between the respective components and specific components described in the embodiments discussed above.

### [First Aspect]

According to a first aspect, a semiconductor device includes a semiconductor module (4), a component-embedded substrate (3), a support substrate (2), and a wiring layer (7). The semiconductor module includes a power semiconductor element (41). The component-embedded substrate has a height equal to a height of the semiconductor module, and includes at least one electronic component (31, 32) embedded in the component-embedded substrate. The at least one electronic component has a height different from the height of the semiconductor module. The semiconductor module and the component-embedded substrate are mounted on the support substrate. The wiring layer includes wiring sections (72) each electrically connected to the power semiconductor element or the at least one electronic component. The wiring layer is disposed on an opposite side of the semiconductor module and the component-embedded substrate from the support substrate. The at least one electronic component has a terminal (311, 321) connected to a corresponding wiring section among the wiring sections. The terminal is disposed, within the component-embedded substrate, at a position closer to the wiring layer than to the support substrate.

### [Second Aspect]

According to a second aspect, in the semiconductor device according to the first aspect, the at least one electronic component includes a plurality of electronic components. The plurality of electronic components respectively have terminal forming surfaces on which terminals connected to corresponding wiring sections among the wiring sections are disposed. The plurality of electronic components are arranged such that the terminal forming surfaces of the plurality of electronic components are aligned. Among the plurality of electronic components, an electronic component having a greatest height among the plurality of electronic components is defined as a highest electronic component, and an electronic component other than the highest electronic component is defined as a different electronic component. The component-embedded substrate further includes a prepreg layer (331) and an auxiliary core layer (333). The prepreg layer is in contact with the highest electronic component. The auxiliary core layer is disposed on the different electronic component, fills a gap between the different electronic component and the prepreg layer, and has a continuous shape surrounding the highest electronic component.

### [Third Aspect]

According to a third aspect, in the semiconductor device according to the first aspect or the second aspect, the at least one electronic component includes a plurality of electronic components. The plurality of electronic components respectively have terminal forming surfaces on which terminals connected to corresponding wiring sections among the wiring sections are disposed. The plurality of electronic components are arranged such that the terminal forming surfaces of the plurality of electronic components are aligned. The component-embedded substrate further includes a core layer (332), a prepreg layer (331), and an independent auxiliary core layer (335). The core layer has a continuous frame shape surrounding the plurality of electronic components. The prepreg layer is in contact with the core layer. The independent auxiliary core layer is fixed to at least one of the plurality of electronic components, is disposed between the at least one of the plurality of electronic components and the prepreg layer, and is independent from the core layer.

### [Fourth Aspect]

According to a fourth aspect, in the semiconductor device according to any one of the first to third aspects, the component-embedded substrate further includes a wiring member (35) connected to the terminal. The wiring member of the component-embedded substrate has a multilayer structure in which a plurality of wiring layers are stacked.

### [Fifth Aspect]

According to a fifth aspect, in the semiconductor device according to any one of the first to fourth aspects, the at least one electronic component includes a plurality of electronic components. The plurality of electronic components respectively have terminal forming surfaces on which terminals connected to corresponding wiring sections among the wiring sections are disposed, and heat dissipation surfaces opposite to the terminal forming surfaces. The plurality of electronic components are arranged such that the terminal forming surfaces of the plurality of electronic components are aligned. The component-embedded substrate further includes a heat dissipation wiring section that is connected to at least one of the heat dissipation surfaces of the plurality of electronic components.

### [Sixth Aspect]

According to a sixth aspect, in the semiconductor device according to any one of the first to fourth aspects, the component-embedded substrate includes a first member (3A) and a second member (3B). The at least one electronic component includes a plurality of electronic components embedded in the first member and a plurality of electronic components embedded in the second member. The plurality of electronic components respectively have terminal forming surfaces on which terminals connected to corresponding wiring sections among the wiring sections are disposed. The first member has one surface on which the terminal forming surfaces of the plurality of electronic components embedded in the first member are aligned, and a rear surface opposite to the one surface. The second member has one surface on which the terminal forming surfaces of the plurality of electronic components embedded in the second member are aligned, and a rear surface opposite to the one surface. The rear surface of the first member and the rear surface of the second member are joined to each other.

## Claims

1. A semiconductor device comprising:
a semiconductor module (4) including a power semiconductor element (41);
a component-embedded substrate (3) having a height equal to a height of the semiconductor module, and including at least one electronic component (31, 32) embedded in the component-embedded substrate, the at least one electronic component having a height different from the height of the semiconductor module;
a support substrate (2) on which the semiconductor module and the component-embedded substrate are mounted; and
a wiring layer (7) including wiring sections (72) each electrically connected to the power semiconductor element or the at least one electronic component, the wiring layer disposed on an opposite side of the semiconductor module and the component-embedded substrate from the support substrate, wherein
the at least one electronic component has a terminal (311, 321) connected to a corresponding wiring section among the wiring sections, and
the terminal is disposed, within the component-embedded substrate, at a position closer to the wiring layer than to the support substrate.

2. The semiconductor device according to claim 1, wherein
the at least one electronic component includes a plurality of electronic components, the plurality of electronic components respectively have terminal forming surfaces on which terminals connected to corresponding wiring sections among the wiring sections are disposed, and the plurality of electronic components are arranged such that the terminal forming surfaces of the plurality of electronic components are aligned,
among the plurality of electronic components, an electronic component having a greatest height among the plurality of electronic components is defined as a highest electronic component, and an electronic component other than the highest electronic component is defined as a different electronic component, and
the component-embedded substrate further includes:
a prepreg layer (331) that is in contact with the highest electronic component; and
an auxiliary core layer (333) that is disposed on the different electronic component, fills a gap between the different electronic component and the prepreg layer, and has a continuous shape surrounding the highest electronic component.

3. The semiconductor device according to claim 1 or 2, wherein
the at least one electronic component includes a plurality of electronic components, the plurality of electronic components respectively have terminal forming surfaces on which terminals connected to corresponding wiring sections among the wiring sections are disposed, and the plurality of electronic components are arranged such that the terminal forming surfaces of the plurality of electronic components are aligned,
the component-embedded substrate further includes:
a core layer (332) that has a continuous frame shape surrounding the plurality of electronic components;
a prepreg layer (331) that is in contact with the core layer; and
an independent auxiliary core layer (335) that is fixed to at least one of the plurality of electronic components, disposed between the at least one of the plurality of electronic components and the prepreg layer, and independent from the core layer.

4. The semiconductor device according to any one of claims 1 to 3, wherein
the component-embedded substrate further includes a wiring member (35) connected to the terminal, and
the wiring member of the component-embedded substrate has a multilayer structure in which a plurality of wiring layers are stacked.

5. The semiconductor device according to any one of claims 1 to 4, wherein
the at least one electronic component includes a plurality of electronic components,
the plurality of electronic components respectively have terminal forming surfaces on which terminals connected to corresponding wiring sections among the wiring sections are disposed, and have heat dissipation surfaces opposite to the terminal forming surfaces,
the plurality of electronic components are arranged such that the terminal forming surfaces of the plurality of electronic components are aligned, and
the component-embedded substrate further includes a heat dissipation wiring section that is connected to at least one of the heat dissipation surfaces of the plurality of electronic components.

6. The semiconductor device according to any one of claims 1 to 4, wherein
the component-embedded substrate includes a first member (3A) and a second member (3B), the at least one electronic component includes a plurality of electronic components embedded in the first member and a plurality of electronic components embedded in the second member,
the plurality of electronic components respectively have terminal forming surfaces on which terminals connected to corresponding wiring sections among the wiring sections are disposed,
the first member has one surface on which the terminal forming surfaces of the plurality of electronic components embedded in the first member are aligned, and a rear surface opposite to the one surface,
the second member has one surface on which the terminal forming surfaces of the plurality of electronic components embedded in the second member are aligned, and a rear surface opposite to the one surface, and
the rear surface of the first member and the rear surface of the second member are joined to each other.
